(19) Europäisches Patentamt
European Patent Office
Office européen des brevets

(11) **EP 2 391 015 A1**

(12) **EUROPÄISCHE PATENTANMELDUNG**

(43) Veröffentlichungstag:
  **30.11.2011 Patentblatt 2011/48**

(51) Int Cl.:
  **H03M 7/30** (2006.01)

(21) Anmeldenummer: **10005653.0**

(22) Anmeldetag: **31.05.2010**

(84) Benannte Vertragsstaaten:
  **AL AT BE BG CH CY CZ DE DK EE ES FI FR GB
  GR HR HU IE IS IT LI LT LU LV MC MK MT NL NO
  PL PT RO SE SI SK SM TR**
  Benannte Erstreckungsstaaten:
  **BA ME RS**

(71) Anmelder: **Fraunhofer-Gesellschaft zur
  Förderung der
  angewandten Forschung
  80686 München (DE)**

(72) Erfinder:
  • **Dehning, Carsten
    53797 Lohmar-Geber (DE)**
  • **Bürger, Markus
    53115 Bonn (DE)**
  • **Rümpler, Christian
    53347 Alfter-Oedekoven (DE)**

(74) Vertreter: **Pfenning, Meinig & Partner GbR
  Patent- und Rechtsanwälte
  Theresienhöhe 13
  80339 München (DE)**

(54) **Verfahren und Vorrichtung zur Kompression von Daten**

(57) Die vorliegende Erfindung betrifft ein Verfahren zur Kompression von Daten, wobei die Daten in einem d-dimensionalen Gebiet vorliegen, wobei das Gebiet als eine übergeordnete Kachel gesetzt wird, und danach in einem Teilungsschritt die übergeordnete Kachel in eine Mehrzahl von d-dimensionalen untergeordneten Kacheln unterteilt wird, so dass eine Vereinigung aller der in diesem Teilungsschritt erzeugten untergeordneten Kacheln kongruent zur Vereinigung aller in diesem Teilungsschritt unterteilten übergeordneten Kacheln ist und eine Schnittmenge zweier unterschiedlicher untergeordneter Kacheln leer ist oder ein maximal (d-1)-dimensionaler Rand beider untergeordneter Kacheln ist, dann in einem Approximationsschritt für jede der untergeordneten Kacheln zumindest eine approximierende Funktion zur Approximation der Daten in der entsprechenden untergeordneten Kachel ermittelt wird, dann in einem Fehlerbestimmungsschritt ein Fehler der approximierenden Funktionen im Vergleich zu den Daten ermittelt wird, und dann in einem Entscheidungsschritt wenn der Fehler einen Schwellenwert unterschreitet, Daten, welche die untergeordneten Kacheln und die auf ihnen ermittelten approximierenden Funktionen beschreiben, als komprimierte Daten gesetzt werden, und wenn der Fehler größer ist als der Schwellenwert zumindest ein Teil der untergeordneten Kacheln als übergeordnete Kacheln gesetzt werden, für diese jeweils der Teilungsschritt und der Approximationsschritt durchgeführt wird und für alle untergeordneten Kacheln der Fehlerbestimmungsschritt und der Entscheidungsschritt durchgeführt wird.

Fig. 1

EP 2 391 015 A1

EP 2 391 015 A1

**Beschreibung**

Die Erfindung betrifft ein Verfahren und eine Komprimierungsvorrichtung zur Kompression von Daten, mit welchen Daten so komprimierbar sind, dass eine Auswertung der Daten unmittelbar auf den komprimierten Daten ohne eine vorhergehende Dekompression erfolgen kann.

Numerische Simulationen produzieren je nach Anwendungsgebiet mehrdimensionale bis hochdimensionale Datensätze oder benötigen diese als Grundlage für weitere Berechnungen. Ein Problem entsteht, wenn diese Datenmengen so groß werden, dass sie das technisch mögliche Speichervolumen der verfügbaren Computer ausschöpfen oder überschreiten.

Eine mögliche Lösung basiert darauf, jene Modelle, welche die Grundlage der numerischen Simulationen sind, drastisch zu vereinfachen, so dass daraus weniger umfangreiche oder gar niederdimensionale Datensätze resultieren.

Eine andere Möglichkeit besteht darin, die Daten durch herkömmliche Kompressionsprogramme (zip etc.) im Dateisystem komprimiert zu hinterlegen. Ein wesentlicher Nachteil dieser Vorgehensweise ist, dass eine schnelle Operation auf derart komprimierten Daten nicht möglich ist. Vor der Verwendung der Daten in numerischen Simulationen müssen diese zunächst dekomprimiert werden. Letzteres Verfahren ist darüberhinaus auch ungeeignet, wenn die dekomprimierten Daten nicht in den Arbeitsspeicher des Computers passen.

Aufgabe der vorliegenden Erfindung ist es daher, ein Verfahren und eine Vorrichtung zur Kompression von Daten anzugeben, die schnelle Operationen, insbesondere Auswertungen, auf den komprimierten Daten ermöglichen und insbesondere eine Auswertung ohne vorherige Dekompression der Daten ermöglichen.

Die Aufgabe wird gelöst durch das Verfahren zur Kompression von Daten nach Anspruch 1, das Verfahren zum Speichern und/oder Senden von Daten nach Anspruch 11, das Verfahren zum Auslesen von Daten und/oder zum Empfangen von Daten nach Anspruch 12, die Komprimierungsvorrichtung zur Kompression von Daten nach Anspruch 13 und die Auswertungsvorrichtung nach Anspruch 15. Die jeweiligen abhängigen Ansprüche geben vorteilhafte Weiterbildungen der erfindungsgemäßen Verfahren und der erfindungsgemäßen Komprimierungsvorrichtung an.

Das erfindungsgemäße Verfahren zur Kompression von Daten macht sich die Eigenschaften der Daten durch eine mathematische Betrachtung als, vorzugsweise hochdimensionale, Funktion zu Nutze und kann daher geeignete Ansatzfunktionen für eine genaue Approximation unter Beibehaltung analytischer Eigenschaften der Daten verwenden. Die Datenkompression wird letztlich dadurch bewirkt, dass das erfindungsgemäße Verfahren viele Freiheitsgrade der ursprünglichen Daten durch wenige Ansatzfunktionen ersetzt. Unter einer Kompression wird vorzugsweise ein Verfahren verstanden, dass auf unkomprimierte Daten angewendet wird und als Komprimierte Daten Daten erzeugt, die eine kleinere Größe haben als die unkomprimierten.

Es wird zunächst davon ausgegangen, dass die zu komprimierenden Daten in einem d-dimensionalen Gebiet vorliegen. Unter einem Gebiet wird hier eine Teilmenge jenes Raumes verstanden, in welchem die Daten vorliegen, wobei die Teilmenge alle zu komprimierenden Daten umfasst. Erfindungsgemäß wird nun das Gebiet in eine Menge von d-dimensionalen Hyperquadern zerlegt, die synonym auch als Kacheln bezeichnet werden sollen. Ein Hyperquader ist also eine Teilmenge des Gebiets mit gleicher Dimensionalität wie das Gebiet, und erstreckt sich in dem Gebiet in jeder Dimension innerhalb eines Intervalls in dieser Dimension, wobei das Intervall kleiner oder gleich der Ausdehnung des Gebietes in der entsprechenden Dimension ist.

Die grundsätzliche Idee der Erfindung liegt darin, das Gebiet, in dem die Daten vorliegen, in derartige Hyperquader zu zerlegen und auf jedem dieser Hyperquader eine geeignete Approximation der zu komprimierenden Daten innerhalb dieses Hyperquaders zu konstruieren.

Es wird hierzu zunächst das Gebiet als übergeordnete Kachel bzw. übergeordneter Hyperquader gesetzt.

Es folgt nun ein Teilungsschritt, in welchem die übergeordnete Kachel in eine Mehrzahl von d-dimensionalen untergeordneten Kacheln unterteilt wird. Die Unterteilung wird im Teilungsschritt dabei so durchgeführt, dass eine Vereinigung aller in diesem Teilungsschritt erzeugten untergeordneten Kacheln kongruent zur Vereinigung aller in diesem Teilungsschritt unterteilten übergeordneten Kacheln ist. Sofern zunächst nur das Gebiet als übergeordnete Kachel unterteilt wird, ist die Vereinigung aller in diesem Teilungsschritt erzeugten untergeordneten Kacheln gerade das Gebiet. Im weiteren Verlauf des Verfahrens werden jedoch untergeordnete Kacheln als übergeordnete Kacheln gesetzt und im Teilungsschritt weiter unterteilt, wobei auch mehrere dieser als übergeordnete Kacheln gesetzten Kacheln im gleichen Teilungsschritt unterteilt werden können. In diesem Falle ist also die Vereinigung aller in diesem Teilungsschritt erzeugten unterordneten Kacheln kongruent zur Vereinigung aller in diesem Teilungsschritt unterteilten übergeordneten Kacheln. Darüberhinaus wird der Teilungsschritt so durchgeführt, dass eine Schnittmenge zweier unterschiedlicher ungeordneter Kacheln entweder leer ist oder ein maximal (d-1)-dimensionaler Rand der beiden untergeordneten Kacheln ist. Vorzugsweise ist die Schnittmenge gerade genau dann ein Rand, wenn die beiden untergeordneten Kacheln aneinandergrenzen, ansonsten ist sie die leere Menge.

Es wird nun nach dem vorangegangenen Teilungsschritt ein Approximationsschritt ausgeführt, wobei für jede der untergeordneten Kacheln zumindest eine approximierende Funktion zur Approximation der Daten in der entsprechenden untergeordneten Kachel ermittelt wird. Hierbei sind die untergeordneten Kacheln nicht nur jene untergeordnete Kacheln, die im vorangegangenen Teilungsschritt erzeugt wurden, sondern auch jene untergeordneten Kacheln, die in früheren Teilungsschritten erzeugt wurden und nicht im weiteren Verlauf des Verfahrens als übergeordnete Kacheln gesetzt wurden. Für untergeordnete Kacheln aus Teilungsschritten, die vor dem zuletzt durchgeführten Teilungsschritt ausgeführt wurden, kann die Ermittlung der approximierenden Funktion auch nur im Rückgriff auf Funktionen liegen, die in früheren Approximationsschritten ermittelt wurden, insbesondere in jenem Approximationsschritt, welcher auf den Teilungsschritt folgte, in welchem die entsprechende untergeordnete Kachel erzeugt wurde. Vorzugsweise sind die untergeordneten Kacheln, für die im Approximationsschritt zumindest eine approximierende Funktion zur Approximation der Daten ermittelt wird, alle untergeordneten Kacheln, so dass die Vereinigung der untergeordneten Kacheln kongruent zum Gebiet ist. Dabei wird jedoch vorzugsweise auch der Rückgriff früher ermittelter Funktionen als Approximation im Sinne dieses Approximationsschrittes verstanden.

Es wird nun nach dem Approximationsschritt ein Fehlerbestimmungsschritt ausgeführt, in welchem ein Fehler der approximierenden Funktionen im Vergleich zu den Daten ermittelt wird.

Nach dem Fehlerbestimmungsschritt wird dann ein Entscheidungsschritt ausgeführt, in welchem ermittelt wird, ob der im Fehlerbestimmungsschritt ermittelte Fehler einen vorgegebenen Schwellenwert unterschreitet oder nicht. Wenn der Fehler einen vorgegebenen Schwellenwert unterschreitet, werden Daten, welche die untergeordneten Kacheln und die auf ihnen ermittelten approximierenden Funktionen beschreiben, als komprimierte Daten gesetzt. Derartige Daten können beispielsweise Parameter, Parameterwerte, Koeffizienten, Funktionstypen, die Kachel begrenzende Intervalle und andere sein.

Wird im Entscheidungsschritt ermittelt, dass der Fehler, der im Fehlerbestimmungsschritt ermittelt wurde, größer ist als der vorgegebene Schwellenwert, so wird zumindest ein Teil der untergeordneten Kacheln, also jener untergeordneten Kacheln, die zum Zeitpunkt dieser Entscheidung als untergeordnete Kacheln bestehen, sei es aus dem zuletzt vorangegangenen Teilungsschritt oder aus früheren Teilungsschritten, als übergeordnete Kacheln gesetzt. Vorzugsweise wird dabei je eine untergeordnete Kachel als eine übergeordnete Kachel gesetzt. Möglich ist es aber auch, dass mehrere untergeordnete Kacheln, vorzugsweise unmittelbar benachbarte Kacheln, gemeinsam als eine übergeordnete Kachel gesetzt werden.

Es wird dann nach dem Setzen von untergeordneten Kacheln als übergeordnete Kacheln für diese durch das Setzen neu entstandenen übergeordneter Kacheln wiederum jeweils der Teilungsschritt und der Approximationsschritt nacheinander durchgeführt, wie sie vorstehend beschrieben worden sind. Danach wird dann wieder für eine, mehrere oder alle untergeordneten Kacheln, also sowohl jene, die im letzten Teilungsschritt erzeugt wurden als auch jene aus früheren Teilungsschritt entstandenen, die nicht als übergeordnete Kacheln gesetzt wurden, der Fehlerbestimmungsschritt durchgeführt und für diese oder alle Kacheln der Entscheidungsschritt durchgeführt. Vorzugsweise wird das Verfahren so lange unter Wiederholung der genannten Schritte durchgeführt, bis der im Fehlerbestimmungsschritt ermittelte Fehler im Entscheidungsschritt als einen Schwellenwert unterschreitend bestimmt wird. Es werden dann wie beschrieben Daten, welche die zuletzt bestehenden untergeordneten Kacheln und die auf ihnen ermittelten approximierenden Funktionen beschreiben, als komprimierte Daten gesetzt.

Das erfindungsgemäße Verfahren ist vorzugsweise ein Verfahren oder Teil eines Verfahrens zur Verarbeitung von Messwerten und/oder Simulationsergebnissen. Gerade in diesen Fällen besteht nämlich besonders häufig und in besonders ausgeprägter Form das Problem, dass die verarbeitende Hardware zu langsam zur Verarbeitung der eigentlichen Messergebnisse bzw. Simulationsergebnisse ist oder die Speicherkapazität hierfür nicht ausreicht. Werden die Mess- und/oder Simulationsergebnisse jedoch mittels des erfindungsgemäßen Verfahrens verarbeitet, so ist auch die Verarbeitung komplexer Mess- und/oder Simulationsergebnisse mit verhältnismäßig geringem Hardwareaufwand möglich.

Das Problem besteht also darin, dass Messungen bzw. Simulationen sehr aufwendig sein können und daher normalerweise zunächst erstellt und gespeichert werden müssen, bevor sie in weiteren Simulationen verwendet werden können. Die dabei benötigten Speicherkapazitäten bzw. Übertragungskapazitäten sind sehr hoch, so dass eine Kompression erforderlich ist. Während herkömmliche Kompressionsalgorithmen jedoch das Verfahren stark verlangsamen und einer Dekompression vor der Auswertung erfordern, die ihrerseits einen hohen Speicher- und/oder Übertragunskapazitätsbedarf haben, erlaubt das erfindungsgemäße Verfahren eine schnelle Auswertung ohne vorherige Dekompression, so dass nur geringe Anforderungen an Rechenleistung, Langzeitspeicher und Arbeitsspeicher erforderlich sind.

Vorteilhaft an dem beschriebenen Verfahren ist, dass bei vorgegebener Fehlertoleranz sehr hohe Kompressionsraten erzielt werden, so dass selbst umfangreiche Datensätze nach der Kompression mit nur geringem Genauigkeitsverlust verarbeitbar sind und in Speicherelementen von Computern speicherbar sind. Ein weiterer Vorteil besteht darin, dass die Daten nicht, wie bei herkömmlichen Kompressionsverfahren, vor der Verwendung dekomprimiert werden müssen, um sie auswerten zu können. Vielmehr können Algorithmen auf den komprimierten Daten im Hauptspeicher des Computers schnell und mit wahlfreiem Zugriff operieren. Das Verfahren kann überall dort angewendet werden, wo die Größe, d.h. die Menge, von Daten zum Problem wird. Dies ist insbesondere bei Anwendungen der Fall, die einen schnellen und wahlfreien Zugriff auf mehrdimensionale oder hochdimensionale Daten bei kleinen Fehlertoleranzen verlangen.

Das oben beschriebene Verfahren kann auf verschiedene Weisen durchgeführt werden. Zunächst sind unterschiedliche Wege möglich, wie im Teilungsschritt die übergeordneten Kacheln in untergeordnete Kacheln unterteilt werden können. Eine Unterteilung einer übergeordneten Kachel erfolgt vorzugsweise stets entlang einer (d-1)-dimensionalen Hyperebene. Die entsprechende Hyperebene teilt die Kachel jeweils von deren einem Rand bis zum gegenüberliegenden Rand. Die Teilung kann hierbei so durchgeführt werden, dass in jedem Teilungsschritt nur eine übergeordnete Kachel unterteilt wird. Es wurde also im vorangegangenen Entscheidungsschritt nur eine der untergeordneten Kacheln als übergeordnete Kachel gesetzt. In diesem Fall ist also eine Vereinigung aller in diesem Teilungsschritt erzeugten untergeordneten Kacheln kongruent zur übergeordneten Kachel.

Es ist jedoch auch möglich, dass im Teilungsschritt mehrere übergeordnete Kacheln gleichzeitig in untergeordnete Kacheln unterteilt werden. Dies kann vorzugsweise so geschehen, dass mehrere benachbarte übergeordnete Kacheln entlang gemeinsamer (d-1)-dimensionaler Teilungshyperebenen unterteilt werden. Vorzugsweise können dann alle untergeordneten Kacheln, die von der entsprechenden Hyperebene geschnitten werden, in einem Teilungsschritt entlang dieser Hyperebene unterteilt werden. Hierzu ist jedoch Voraussetzung, dass im vorangegangenen Entscheidungsschritt alle jene unterordneten Kacheln, die von der Teilungshyperebene durchschnitten werden, als übergeordnete Kacheln gesetzt wurden. In diesem Fall ist daher eine Vereinigung aller durch Teilung entlang dieser Hyperebene erzeugten untergeordneten Kacheln kongruent zu einer Vereinigung der durch diese Hyperebene unterteilten übergeordneten Kacheln.

Es ist wie beschrieben möglich, Teilungen von übergeordneten Kacheln, die nur die übergeordnete Kachel betreffen, mit Teilungen über mehrere übergeordnete Kacheln entlang einer gemeinsamen Hyperebene zu kombinieren. Das Verfahren kann auch so durchgeführt werden, dass in jedem Teilungsschritt nur eine übergeordnete Kachel unterteilt wird oder dass in jedem Teilungsschritt stets mehrere Kacheln entlang gemeinsamen Hyperebenen unterteilt werden. Darüberhinaus ist es auch möglich, in einigen Teilungsschritten mehrere übergeordnete Kacheln und/oder alle übergeordnete Kacheln, die von einer Hyperebene geschnitten werden, gemeinsam zu unterteilen und in anderen Teilungsschritten während des gleichen Verfahrensablaufs nur eine übergeordnete Kachel zu unterteilen.

Vorzugsweise wird in Bereichen, in welchen die zu approximierenden Daten eine große Volatilität, vorzugsweise einen großen Gradienten aufweisen, feiner unterteilt, was bedeutet, dass mehr untergeordnete Kacheln erzeugt werden. Weisen die approximierenden Daten hingegen in einem Gebiet einen geringen Gradienten auf, so wird hier vorzugsweise in weniger untergeordnete Kacheln unterteilt. Es können also jene Bereiche der zu komprimierenden Daten, in welchen die Daten einen großen Gradienten aufweisen, feiner in untergeordnete Kacheln unterteilt werden, als jene Bereiche, in welchen die zu approximierenden Daten einen geringen Gradienten aufweisen.

Gemäß dem erfindungsgemäßen Verfahren werden also die ursprünglichen, zu komprimierenden Daten, beispielsweise mehrdimensionale (über-) abgetastete Werte, die aus Messungen oder numerischen Berechnungen stammen, als (vorzugsweise reellwertige) Funktionen, über einem mehrdimensionalen Gebiet aufgefasst. Die Kompression besteht dabei also in der Approximation dieser Funktion mit Hilfe von vorzugsweise möglichst wenigen aber geeigneten Basisfunktionen. Die Speicherung dieser Basisfunktionen und der zugehörigen Koeffizienten sowie der Beschreibung der Kacheln bedarf substantiell weniger Speicherplatz als die originalen Daten. Die Träger, d.h. die Kacheln bzw. Hyperquader, der verwendeten Basisfunktionen sind zueinander disjunkt oder haben gemeinsame Ränder. Die Speicherung der Basisfunktion, Koeffizienten und Kacheln liefert in natürlicher Weise die Kompression. Dass die Basisfunktionen zueinander disjunkt sind oder einen gemeinsamen Rand haben, garantiert eine hohe Geschwindigkeit bei der Auswertung der komprimierten Daten, da im Gegensatz zu beispielsweise hierarchischen Verfahren, wie beispielsweise solche basierend auf FourierTransformation, Wavelet-Transformation oder Dünngittertransformation, zu jedem Abfragepunkt lediglich eine von der Beschaffenheit der Originaldaten und der Approximationsgenauigkeit unabhängigen Anzahl von Basisfunktionen ausgewertet werden muss. Ferner bedarf die Auswertung der komprimierten Daten keiner vorherigen Dekompression, so dass in der elektronischen Verarbeitung der Daten gegenüber ihrer Speicherung kein zusätzlicher Speicheraufwand entsteht.

Vorzugsweise werden aus dem Gebiet der Daten durch die Unterteilungen eine Menge von Kacheln erzeugt, so dass eine Linearkombination der auf den Kacheln definierten Funktionen, vorzugsweise Basisfunktionen, die Originaldaten optimal approximieren. Optimal bedeutet hierbei, dass ein gegebenes, vorzugsweise benutzerdefiniertes, Fehlerkriterium eine vorgegebene Schwelle unterschreitet und dass andererseits so wenig wie möglich Kacheln erzeugt werden. Wie oben beschrieben wird im Ablauf des Verfahrens nach Unterteilung zunächst das Fehlerkriterium ausgewertet und anschließend eine oder mehrere Kacheln der entstandenen Kacheln durch kleinere untergeordnete Kacheln ersetzt, wenn die Fehlertoleranzgrenze noch nicht unterschritten worden ist. Durch die Unterteilung der übergeordneten Kacheln kann sich der nach dem Fehlerkriterium bestimmte Fehler vorzugsweise nicht vergrößern, in der Regel verkleinert er sich. Der Vorgang wird wiederholt, bis die Toleranzgrenze endgültig unterschritten wird.

Bevorzugterweise wird in dem Fehlerbestimmungsschritten jeweils eine Fehlerfunktion ermittelt, die den Fehler ortsabhängig in zumindest einem Teil des Gebiets oder in dem gesamten Gebiet beschreibt. Die Unterteilung der jeweiligen übergeordneten Kacheln in den Teilungsschritten erfolgt dann vorzugsweise anhand dieser Fehlerfunktion.

Das Ziel der Fehlerberechnung ist die Beurteilung der Approximationsgüte. Unter Verwendung des bisher erzeugten Satzes an Kacheln, der Originaldaten, den dazugehörigen Auswerteeinheiten und eines Fehlerkriteriums kann vorzugsweise ein Fehlerfunktional erstellt werden.

Besonders bevorzugt erfolgt die Unterteilung im Teilungsschritt, insbesondere wenn die Fehlergrenze nicht unterschritten wurde, adaptiv. Hierfür ist es vorteilhaft, den Fehler in Bezug auf den d-dimensionalen Raum zu beschreiben. Dabei ist es besonders vorteilhaft, wenn die Fehlerberechnung Informationen liefert, die zeigen, wie sich der Fehler im d-dimensionalen Gebiet verteilt und/oder wo der Fehler ein Maximum annimmt. Vorteilhafterweise liefert der Fehlerbestimmungsschritt außerdem ein Verhalten des Fehlers abseits des Maximums.

Die Fehlerverteilung im Gebiet bzw. das Maximum des Fehlers kann im Verfahren zur Auswahl verwendet werden, welche der vorliegenden untergeordneten Kacheln im Entscheidungsschritt als übergeordnete Kacheln gesetzt werden. Darüberhinaus können aus diesen Informationen die Hyperebenen bestimmt werden, entlang derer im folgenden Teilungsschritt die übergeordneten Kacheln unterteilt werden. Insbesondere über das Verhalten des Fehlers abseits des Maximums kann diejenige Teilungsrichtung bzw. Hyperebene ausgewählt werden, entlang derer eine Teilung den danach bestimmten globalen Fehler am stärksten verkleinert.

Zur Feststellung der Approximationsgüte, z.B. definiert als $e:=\|f\text{-}g\|$, sind auch globale Normen und/oder Metriken, wie z.B. Lebesgue-Norm $L_p$, Sobolev-Normen $W^qp$ und Wasserstein-Metrik möglich, wenn eine kontinuierliche Interpretation der Ursprungsdaten mit entsprechenden Voraussetzungen wie stetiger Differenzierbarkeit, Integrierbarkeit und/oder anderen vorliegt. Auch sind diverse Vektornormen verwendbar, die als

$$\|f - g\|_{l_p} := \left\{ \left( \sum_{i=0}^{n} |f_i - g_i|^p \right)^{\frac{1}{p}} \right\}$$

, mit n als Anzahl aller Werte der Ursprungsdaten und $g_i$ als die approximierende Funktion am i-ten Punkt auf den Originaldaten definiert sind.

Solche sind insbesondere anwendbar, falls auch die Approximierende punktweise an denselben Freiheitsgraden betrachtet wird wie f.

Darüberhinaus sind auch all diejenigen Normen und/oder Metriken zur Bestimmung der Approximationsgüte einsetzbar, die aus den oben genannten abgeleitet sind. Dies betrifft z.B. die Bildung der $L_p$-Norm oder $W^qp$ unter Verwendung von Integrationskernen, wie z.B. einem Gaußkern.

Insbesondere zur Betrachtung der Verhaltens des Fehlers abseits des Maximums eignet sich z.B. auch die Maximumsnorm oder andere, insbesondere benutzerdefinierte Fehlerfunktionen, die den punktweisen Fehler auf dem d-dimensionalen Gebiet wiederspiegeln. Als besonders effizient hat sich eine Fehlerfunktion herausgestellt, die den punktweisen Fehler in Relation zur maximalen Ausdehnung der Originaldaten in einer benutzerdefinierbaren Umgebung um den Punkt betrachtet. Eine solche Fehlerfunktion e kann den ortsabhängigen Fehler in einer Umgebung $D(x)$ um einen Ort x in dem Gebiet angeben als $e(x):=|f(x)\text{-}g(x)|(M(x)\text{-}m(x))$ mit $M(x):=\max_{p \in D(x)}(f(p))$ und $m(x):=\min_{p \in D(x)}(f(p))$.

$D(x)$ ist dabei eine, vorzugsweise benutzerdefinierte, Funktion, die eine Punktmenge um einen Punkt x liefert. Grundsätzlich ist es für die Bestimmung des Verhaltens des Fehlers außerhalb des Maximums vorteilhaft, ein (lokales) Fehlermaß für jeden einzelnen Punkt im d-dimensionalen Gebiet zu haben. Daher eignen sich außerdem auch all jene Normen und/oder Metriken, die zur Bestimmung der Approximationsgüte eingesetzt werden, wenn sie auf geeignete Weise lokal eingeschränkt werden. So z.B. durch Multiplikation mit Kernen oder anderen Funktionen mit kompaktem Träger. Eine Fehlerfunktion kann beispielsweise auch wie folgt definiert sein:

$$e(x) := \|(f(\cdot) - g(\cdot)) * k(x - \cdot)\|_{L_p} := \sqrt[p]{\int ((f(z) - g(z)) * k(x - z))^p \, dz}.$$

mit einem Kern k.

Es sind weiter Normen und/oder Metriken möglich, die spezielle Eigenschaften der Funktionen, wie z.B. Krümmung, Divergenz und/oder Rotation betrachten. So kann z.B. bei der Kompression einer konservativen Funktion, wie beispielsweise einer Geschwindigkeit oder einem Impuls in einer Strömung, die Divergenz der approximierenden Funktion $\nabla \cdot g$ in die Fehlerberechnung einfließen.

Sofern im Teilungsschritt die Fehlerfunktion berücksichtigt wird, ist es besonders vorteilhaft, wenn im Teilungsschritt die gegebene übergeordnete Kachel entlang einer Teilungshyperebene unterteilt wird, so dass ein Maximum der Fehlerfunktion in der betreffenden Kachel auf dieser Hyperebene liegt. Auf diese Weise kann der Fehler bei möglichst kleiner Anzahl an untergeordneten Kacheln besonders effektiv reduziert werden.

Dabei kann auch der maximale Fehler bzw. das Maximum der Fehlerfunktion im gesamten Gebiet ermittelt werden und in jedem Teilungsschritt so unterteilt werden, dass die Teilungsebene diesen Punkt, in welchem das Maximum vorliegt, schneidet. Es ist hierbei auch möglich, dass nur jene Kacheln im Entscheidungsschritt als übergeordnete Kacheln gesetzt werden, die von Ebenen durchschnitten werden, in welchen dieses Maximum liegt, während die anderen untergeordneten Kacheln nicht weiter unterteilt werden. Da das Maximum in jedem Teilungsschritt woanders liegen kann, werden im Normalfall unterschiedliche Kacheln als übergeordnete Kacheln gesetzt. In diesem Beispiel würde eine Unterteilung stets das ganze Gebiet entlang der entsprechenden Ebene unterteilen. Wie beschrieben ist es aber auch möglich, das Maximum jeweils innerhalb einer gegebenen Kachel zu suchen und nur diese Kachel entlang von Ebenen zu unterteilen, so dass das Maximum innerhalb dieser Kachel auf der entsprechenden Ebene liegt. Die Ebenen sind vorzugsweise (d-1)-dimensionale Hyperebenen im d-dimensionalen Gebiet.

Es ist möglich, die Teilungspunkte und Teilungsrichtungen automatisch zu bestimmen, insbesondere so dass die Zahl der durch die Teilung entstehenden untergeordneten Kacheln minimiert wird. Dies ist z.B. dadurch möglich, dass automatisch verschiedene Teilungspunkte und/oder Teilungsrichtungen ausprobiert werden.

Jene im Approximationsschritt zur Approximation der Daten verwendeten Funktionen können besonders vorteilhaft durch eine Linearkombination von zumindest zwei jeweils mit einem Koeffizienten multiplizierten und vorzugsweise orthogonalen Basisfunktionen gebildet werden. Vorzugsweise werden dabei die Funktionen und Koeffizienten so gewählt, dass die approximierende Funktion auf einer Kachel stetig und besonders bevorzugt stetig differenzierbar, am Rand der Kachel zu einer benachbarten Kachel in die approximierende Funktion der entsprechenden benachbarten Kachel übergeht. Vorteilhafterweise werden die Koeffizienten aus den Daten ermittelt, während die Basisfunktionen vorgegeben werden. Die Basisfunktionen können dabei entsprechend den zu approximierenden Daten ausgewählt werden. Bevorzugterweise werden hier solche Basisfunktionen gewählt, mit denen sich ein näherungsweises Verhalten der Daten besonders gut approximieren lässt. Allgemein wird vorzugsweise die Basis mit den gleichen Eigenschaften, insbesondere hinsichtlich Stetigkeit und/oder Differenzierbarkeit, gewählt, wie die Daten selbst.

Die approximierende Funktion g(x) wird hierbei vorzugsweise berechnet als $g(x) := \sum_{i=0}^{N} \lambda_{K_i} \bullet b_i(x_K)$ , wobei $x_K \in K$ ein Ort in der Kachel K ist, $b_i$ die Basisfunktionen der Kachel, $\lambda_K$ die Koeffizienten der Kachel und N ist eine natürliche Zahl, wobei $N \geq 1$.

Basisfunktionen werden, wie oben beschrieben, vorzugsweise entsprechend der Beschaffenheit der zu komprimierenden Daten gewählt. Mögliche Basisfunktionen sind u.a.:

- Polynome: konstant, linear, quadratisch, kubisch, ..., bis zum beliebigen Grad p. In d Dimensionen durch Tensorbildung konstruiert, vgl. Multipolynomiale Interpolation/Approximation
- NURBS: Non-uniform rational B-Splines (Parametrisierte Untermannigfaligkeiten)
- Trigonomterische Funktionen, wie etwa Cosinus und Sinus (wie bei Windowed Fourier Transform), wobei jedoch erfindungsgemäß die Kacheln mehrdimensional und in ihrer Größe adaptiv sein können.
- Wavelets: Jede Kachel wird eigenständig einer Kompression durch Wavelets unterzogen.

Eine wie oben beschriebene Bestimmung einer Fehlerfunktion kann bereits vor dem ersten Teilungsschritt durchgeführt werden. Hierbei wird dann eine Fehlerfunktion für das gesamte Gebiet im Vergleich zu einer auf dem gesamten Gebiet definierten trivialen Funktion ermittelt. Im ersten Teilungsschritt kann dann die Unterteilung der übergeordneten Kachel, die gerade das Gebiet ist, anhand dieser Fehlerfunktion erfolgen, so dass, wie bei späteren Unterteilungen, die übergeordnete Kachel, hier also das Gebiet, so unterteilt wird, dass die Zahl der untergeordneten Kacheln, die bei dieser Teilung entsteht, möglichst klein ist und der gemäß der Fehlerfunktion bestimmte Fehler möglichst klein ist.

Ein besonderer Vorteil des erfindungsgemäßen Verfahrens liegt darin, dass die approximierende Funktion einer Kachel ermittelt werden kann, ohne dass approximierende Funktionen oder Daten anderer Kacheln hierauf einen Einfluss haben. Auf jeder Kachel können daher die approximierenden Funktionen ohne Kenntnis der Daten in anderen Kacheln bestimmt werden. Es kann also ein beliebiger Hyperquader als Teilmenge des Gebietes separat betrachtet werden und ohne Betrachtung anderer Teilgebiete des Gebietes hierauf die approximierende Funktion bestimmt werden. Insbesondere ist es daher auch möglich, mit den komprimierten Daten zu arbeiten, ohne Werte von approximierenden Funktionen anderer Kacheln oder anderer Teilgebiete als jene, in welchem die zu untersuchenden Daten vorliegen, heranzuziehen. Sowohl zur Kompression als auch zur Auswertung der komprimierten Daten ist es also möglich, ausschließlich Daten der betrachteten Kachel zu verwenden und ausschließlich die approximierenden Funktionen der betrachteten Kachel auszuwerten. Das Hinzuziehen von approximierenden Funktionen und/oder Daten anderer Kacheln als der betrachteten Kachel würde vorzugsweise keine weitere Kompression bewirken und die Auswertung nicht genauer machen.

Im Folgenden soll eine bevorzugte Möglichkeit beschrieben werden, wie eine approximierende Funktion aus Basisfunktionen konstruiert werden kann. In dieser bevorzugten Ausführungsform sind die Basisfunktionen kubische, hermitesche Splines. Dabei werden für eine gegebene Kachel $K := \underset{i=1}{\overset{d}{\times}}\left[l_{i_0}, l_{i_1}\right]$ $4^d$ Basisfunktionen $\gamma$ definiert als

$$\mathrm{je} \quad \gamma_{\vec{\alpha}_k}(x_{d-1}, ..., x_0) = \prod_{i=0}^{d-1} v_{\alpha_i}(x_{d-1-i})s_i \quad \mathrm{mit} \quad s_i := \left\{ \begin{array}{l} 1, falls\, \alpha_{i_1} = 0 \\ l_{i_1} - l_{i_0}, falls\, \alpha_{i_1} = 1 \end{array} \right\}$$

mit

$$\vec{\alpha}_k = (\alpha_0, ..., \alpha_{d-1}), \ k = 0, ...., 4^d - 1 \ , \ \alpha_i := (\alpha_{i_1}, \alpha_{i_2}) \in \left\{(0,0), (0,1), (1,0), (1,1)\right\}$$

i=0,......,d-1 und $\overleftarrow{\alpha}_k \neq \overleftarrow{\alpha}_l$ für $k \neq l$
wobei

$$v_{00} := 2x^3 - 3x^2 + 1$$

$$v_{01} := -2x^3 + 3x^2$$

$$v_{10} := x^3 - 2x^2 + x$$

$$v_{11} := x^3 - x^2$$

und wobei die approximierende Funktion g der Daten $f(x_0,..., x_{d-1})$ definiert wird als

$$g(x_{d-1}, ....., x_0) = \sum_{\substack{\vec{\alpha}_k \\ k=0...4^d-1}} \gamma_{\vec{\alpha}_k}(x_{d-1}, ......, x_0)\lambda(L_0,..., L_i,..., L_{d-1})$$

wobei

$$\lambda(L_0,..., L_i,..., L_{d-1}) = \frac{\partial^{\left(\sum_{i=0}^{d-1}\alpha_{i_1}\right)}}{(\partial x_0)^{\alpha_{0_1}}.....(\partial x_{d-1})^{\alpha_{d-1_1}}} f(x_0,..., x_{d-1})\Big|_{L_0,..., L_{d-1}}$$

mit $L_i = l_{i_{\alpha_{i_2}}}$ .

Das erfindungsgemäße Verfahren ist besonders bevorzugt einsetzbar als Verfahren oder Teil eines Verfahrens zum Speichern und/oder Senden von Daten. Das erfindungsgemäße Verfahren kann hierbei das Speichern bzw. Senden von Daten in verschiedenen Situationen überhaupt erst möglich machen, da es die Möglichkeit bietet, die Daten mit einem geringen Speicherbedarf und/oder Übertragungskapazitätsbedarf zu speichern bzw. zu senden.

Da erfindungsgemäß die Daten und approximierenden Funktionen auf den Kacheln separat betrachtet werden können, also in einer bestimmten Kachel ohne den Einfluss von Daten bzw. approximierenden Funktionen auf anderen Kacheln, ist es möglich, das erfindungsgemäße Verfahren problemlos in bestehenden Speichervorrichtungen und/oder Datenübertragungsvorrichtungen zur Anwendung zu bringen. Selbst wenn diese bestehenden Vorrichtungen also zur Übertragung der ursprünglichen Daten wegen derer Komplexität oder Menge nicht in der Lage gewesen wären, ist eine Speicherung und/oder Übertragung in dieser Vorrichtung mit dem erfindungsgemäßen Verfahren möglich. Das erforderliche Maß an Kompression kann entsprechend den Gegebenheiten der verwendeten Vorrichtung angepasst werden. Die Anpassung erfolgt hierbei vorzugsweise durch Auswahl der approximierenden Funktionen und Parameter und/oder die Wahl des Schwellenwertes bei der Fehlerbestimmung.

Erfindungsgemäß wird auch ein Verfahren zum Auslesen von Daten aus einem Speicher und/oder zum Empfangen von Daten angegeben, wobei die Daten in einem Verfahren nach einem der vorhergehenden Ansprüche komprimiert sind. Ausgelesen bzw. empfangen werden also die komprimierten Daten, d.h. z.B. die approximierenden Funktionen und die entsprechenden Parameter sowie die die Kacheln beschreibenden Daten. Hierbei wird beim Auslesen und/oder beim Empfangen der Daten eine Auswerteeinheit die auf die ursprünglichen, unkomprimierten Daten anwendbar ist, auf die komprimierten Daten angewendet, also bevorzugt auf die Funktionen jener Kachel, in welcher ein Ort x liegt, an welchem die Auswertung erfolgt. Wäre also die Auswerteeinheit auf die unkomprimierten Daten an einem Ort x im Gebiet angewendet worden, so wird im erfindungsgemäßen Ausleseverfahren bzw. Empfangsverfahren die gleiche Auswerteeinheit auf die komprimierten Daten am Punkt x, also vorzugsweise den Wert der approximierenden Funktion am Ort x, angewendet, wobei die approximierende Funktion die approximierende Funktion jener Kachel ist, in welcher x in den komprimierten Daten liegt. Vor der Auswertung müssen die Daten nicht dekomprimiert werden. Zur Auswertung an einem Punkt x in einer bestimmten Kachel wird hierbei ausschließlich die approximierende Funktion in der betreffenden Kachel herangezogen. Daten und/oder komprimierte Daten bzw. approximierende Funktionen anderer Kacheln als der betrachtenden Kachel werden zur Auswertung nicht herangezogen.

Erfindungsgemäß wird außerdem eine Komprimierungsvorrichtung zur Kompression von Daten, die in einem d-dimensionalen Gebiet vorliegen, angegeben. Eine solche erfindungsgemäße Komprimierungsvorrichtung ist mit einer Setzungsvorrichtung, mit welcher das Gebiet als eine übergeordnete Kachel setzbar ist, einer Teilungsvorrichtung, mit welcher die übergeordnete Kachel in eine Mehrzahl von d-dimensionalen untergeordneten Kacheln unterteilbar ist, so dass eine Vereinigung aller der untergeordneten Kacheln kongruent zur Vereinigung aller in einem vorangegangenen Teilungsschritt unterteilten übergeordneten Kacheln ist, und eine Schnittmenge zweier unterschiedlicher untergeordneter Kacheln leer ist oder ein maximal (d-1)-dimensionaler Rand beider untergeordneter Kacheln ist, einer Approximationseinheit zur Ermittlung zumindest einer approximierenden Funktion für jede der untergeordneten Kacheln zur Approximation der Daten in der entsprechenden untergeordneten Kachel, einer Fehlerbestimmungseinheit, mit welcher ein Fehler der approximierenden Funktionen im Vergleich zu den Daten ermittelbar ist, einer Entscheidungseinheit, mit welcher entscheidbar ist, ob der Fehler einen Schwellenwert unterschreitet, einer Speichereinheit, zum Speichern von Daten, welche die untergeordneten Kacheln und die auf ihnen ermittelten approximierenden Funktionen beschreiben als komprimierte Daten, wenn durch die Entscheidungseinheit festgestellt wird, dass der Schwellenwert unterschritten ist, sowie einer Setzungseinheit, mit welcher, wenn die Entscheidungseinheit entscheidet, dass der Fehler größer ist als der Schwellenwert, zumindest ein Teil der untergeordneten Kacheln als übergeordnete Kacheln setzbar ist und diese der Teilungseinheit und der Approximationseinheit zuführbar sind, wobei, wenn die Entscheidungseinheit feststellt, dass der Fehler größer ist als der Schwellenwert, alle untergeordneten Kacheln der Fehlerbestimmungseinheit und der Entscheidungseinheit zuführbar sind, ausgestattet. Bevorzugt ist mit dieser Komprimierungsvorrichtung das oben beschriebene Kompressionsverfahren durchführbar.

Erfindungsgemäß wird außerdem eine Auswertungsvorrichtung angegeben, mit welcher das oben beschriebene Verfahren zum Auslesen von Daten aus einem Speicher und/oder zum Empfangen von Daten durchführbar ist.

Im Folgenden soll die Erfindung anhand einiger Figuren beispielhaft erläutert werden.

Es zeigt

Figur 1     ein Ablaufdiagramm eines Verfahrens gemäß der vorliegenden Erfindung,

Figur 2     ein Ablaufdiagramm einer Fehlerberechnung,

Figur 3     ein Ablaufdiagramm des Teilens übergeordneter Kacheln mittels einer gegebenen Fehlerfunktion,

Figur 4     ein Beispiel für ein Unterteilen einer Kachel im Teilungsschritt,

Figur 5     ein Beispiel für eine Auswertung von gemäß dem erfindungsgemäßen Verfahren komprimierten Daten,

Figur 6     ein Beispiel von vier Basisfunktionen zur Bildung einer approximierenden Funktion und

Figur 7     ein Beispiel für eine Zuordnung der Basisfunktionen zu einer gegebenen Kachel.

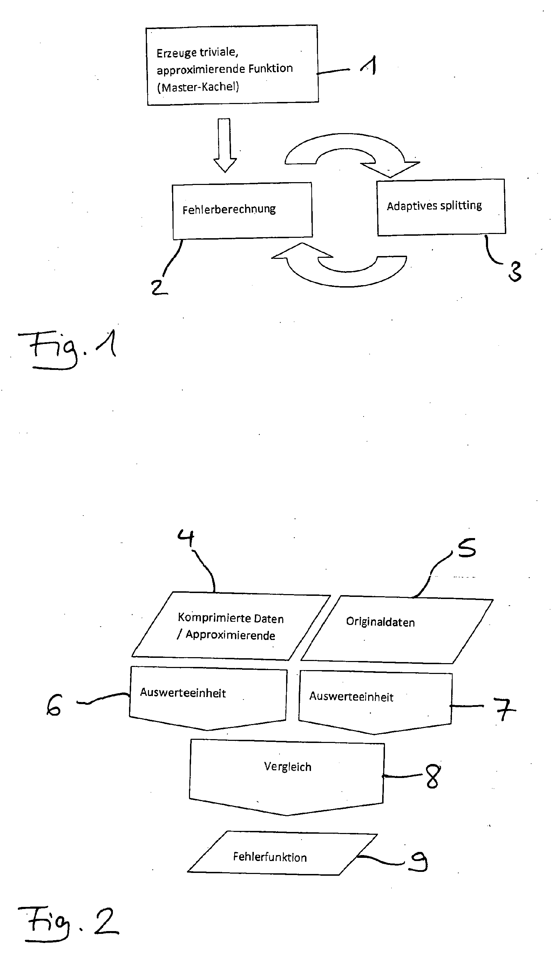

Figur 1 zeigt beispielhaft das grundlegende Prinzip eines Kompressionsvorgangs entsprechend einem Verfahren der vorliegenden Erfindung. Hierbei wird in einem vorausgehenden Schritt zunächst ein d-dimensionales Gebiet, in welchem zu komprimierende Daten vorliegen, als eine übergeordnete Kachel oder Master-Kachel gesetzt. Es ist dann möglich, auf dieser Master-Kachel, d.h. dem gesamten Gebiet, eine approximierende Funktion zu bestimmen, die auch eine triviale approximierende Funktion sein kann. Diese approximierende Funktion wird in einem Schritt 1 erzeugt. Es wird dann ein Fehlerbestimmungsschritt 2 durchgeführt, in welchem ein Fehler der approximierenden Funktion im Vergleich zu den zu approximierenden Daten ermittelt wird. Es kann dann in einem Teilungsschritt 3 die übergeordnete Kachel unter Berücksichtigung des im Fehlerberechnungsschritt 2 bestimmten Fehlers unterteilt werden. Der in Figur 1 gezeigte Ablauf ist beispielhaft für das erfindungsgemäße Verfahren zur Kompression von Daten. Gemäß dem erfindungsgemäßen Verfahren werden Daten, die in einem beispielsweise d-dimensionalen Gebiet vorliegen, komprimiert. Es wird hierbei zunächst das Gebiet als übergeordnete Kachel oder Masterkachel gesetzt und dann in einem Teilungsschritt die übergeordnete Kachel in eine Mehrzahl von d-dimensionalen untergeordneten Kacheln unterteilt, so dass eine Vereinigung aller der in diesem Teilungsschritt erzeugten untergeordneten Kacheln kongruent zu einer Vereinigung aller in diesem Teilungsschritt unterteilten übergeordneten Kacheln ist und außerdem eine Schnittmenge zweier unterschiedlicher untergeordneter Kacheln leer ist oder ein maximal (d-1)-dimensionaler Rand beider untergeordneter Kacheln ist. Es wird dann in einem Approximationsschritt, der in Figur 1 nicht gezeigt ist, für jede der untergeordneten Kacheln zumindest eine approximierende Funktion zur Approximation der Daten in der entsprechenden unterordneten Kachel ermittelt. Die Ermittlung der approximierenden Funktion kann auch darin bestehen, die approximierende Funktion aus der entsprechenden übergeordneten Kachel zu übernehmen und auf den untergeordneten Kacheln zu definieren. Während also die Definitionsmenge dieser Funktion zunächst die übergeordnete Kachel war, werden dann für jede untergeordnete Kachel die approximierenden Funktionen der übergeordneten Kachel auf den untergeordneten Kacheln als Definitionsmenge definiert. Die Werte dieser approximierenden Funktionen sind Approximationen der Daten in der entsprechenden untergeordneten Kachel.

Im Fehlerbestimmungsschritt 2 wird dann ein Fehler der approximierenden Funktionen im Vergleich zu den Daten ermittelt. In einem Entscheidungsschritt werden schließlich, wenn der Fehler einen Schwellenwert unterschreitet, Daten, welche die untergeordneten Kacheln und die auf ihnen ermittelten approximierenden Funktionen beschreiben, als komprimierte Daten gesetzt, was in Figur 1 nicht gezeigt ist. Ist der Fehler größer als der Schwellenwert, wird zumindest ein Teil der untergeordneten Kacheln als übergeordnete Kacheln gesetzt (nicht in Figur 1 gezeigt) und für diese jeweils der Teilungsschritt 3 und der Approximationsschritt (nicht gezeigt) durchgeführt und dann für alle untergeordneten Kacheln der Fehlerbestimmungsschritt 2 und der nicht gezeigte Entscheidungsschritt durchgeführt. In Figur 1 ist das Verfahren beispielhaft so gezeigt, dass im Teilungsschritt die Teilung unter Berücksichtigung des im Fehlerberechnungsschrittes 2 berechneten Fehlers durchgeführt wird. Es ist jedoch nicht notwendig, bei der Teilung den bestimmten Fehler zu berücksichtigen.

Figur 2 zeigt ein Beispiel für eine Fehlerberechnung im Fehlerbestimmungsschritt 2. Hierbei gehen in die Fehlerberechnung zum einen die komprimierten Daten bzw. approximierenden Funktionen 4 ein und zum anderen die ursprünglichen, zu komprimierenden Daten 5. Die komprimierten Daten bzw. approximierenden Funktionen werden in einer Auswerteeinheit 6 ausgewertet und die Originaldaten 5 werden in einer Auswerteeinheit 7 ausgewertet. In einem Vergleich 8 werden dann die ausgewerteten approximierenden Daten bzw. approximierenden Funktionen 4 mit den Originaldaten 5 verglichen und daraus eine Fehlerfunktion 9 ermittelt. Der Vergleich 8 kann hierbei die Approximationsgüte $e: \|f - g\|$ bestimmen, wobei globale Normen und/oder Metriken, wie z.B. Lebesgue-Normen Lp, Sobolev-Normen $W^q p$ und Wasserstein-Metrik verwendbar sind. Auch sind verschiedene Vektornormen einsetzbar, wie sie oben beschrieben sind. Auch aus den genannten Normen und/oder Metriken abgeleitete Normen und/oder Metriken sind verwendbar, z.B. eine Lp-Norm oder $W^q p$ unter Verwendung von Integrationskernen. Auch Maximumsnormen oder andere z.B. benutzerdefinierte Fehlerfunktionen, die einen punktweisen Fehler auf den d-dimensionalen Gebiet wiederspiegeln, sind einsetzbar. Insbesondere hat sich eine Fehlerfunktion e als effizient erwiesen, die in einer Umgebung D(x) um einen Ort x im Gebiet den Fehler angibt als $e(x) := |f(x)-g(x)|/(M(x)-m(x))$ mit $M(x) := max_{p \in D(x)}(f(p))$ und $m(x) := min_{p \in D(x)}(f(p))$.

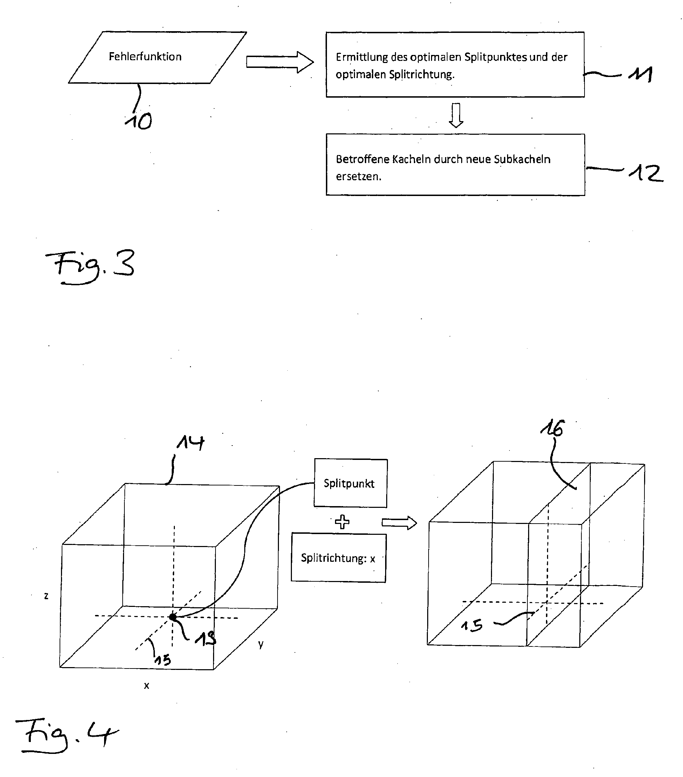

Figur 3 zeigt ein Ablaufdiagramm eines Teilungsschrittes, bei welchem die im Fehlerbestimmungsschritt eingesetzte Fehlerfunktion berücksichtigt wird. Die Fehlerfunktion 10 ermöglicht hierbei die Ermittlung eines optimalen Teilungspunktes bzw. Splitpunktes sowie einer optimalen Teilungsrichtung. Die Teilungsrichtung ist hierbei gegeben durch eine Teilungsebene, an welcher eine gegebene Kachel unterteilt wird. Eine Teilungsebene ist hierbei eine (d-1)-dimensionale Hyperebene. Die unterteilten übergeordneten Kacheln werden dann im Schritt 12 durch untergeordnete Kacheln ersetzt, die wie oben beschrieben durch Teilung der übergeordneten Kachel entlang des optimalen Splitpunktes und der optimalen Splitrichtung erhalten wurden.

Figur 4 zeigt beispielhaft eine dreidimensionale Kachel 14 (d ist hier also 3) sowie deren Unterteilung. Hierbei wird ein Splitpunkt 13 festgelegt, der innerhalb der Kachel 14 liegt. Es wird dann auch eine Splitrichtung 15 festgelegt, hier die x-Richtung. Die Unterteilung der Kachel 14 erfolgt dann an einer Hyperebene 16, die im gezeigten Beispiel entsprechend der Unterteilungsrichtung x 15 senkrecht auf der x-Achse steht. Diese Hyperebene 16 ist hierbei eine 3-1-dimensionale Ebene.

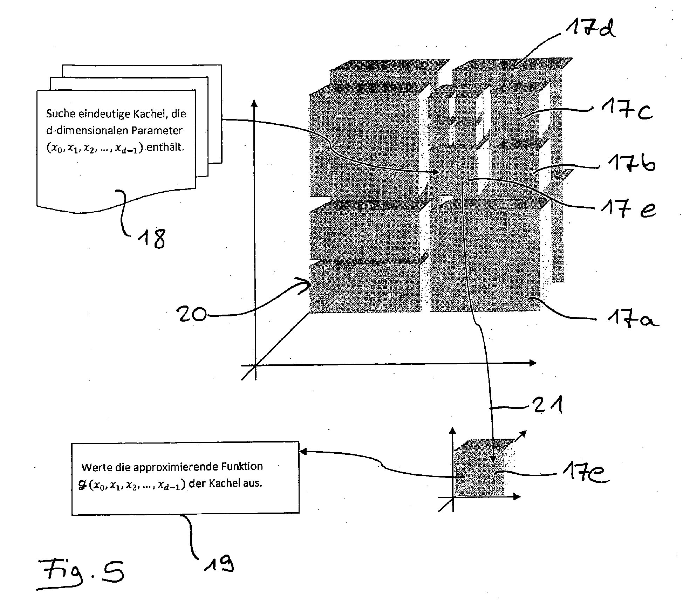

Figur 5 zeigt ein Beispiel einer Auswertung von Daten entsprechend der vorliegenden Erfindung, die entsprechend dem oben beschriebenen Verfahren komprimiert wurden. Hierbei wird ein Gebiet 20 betrachtet, welches im vorliegenden Fall dreidimensional ist (d ist also 3). Im Laufe des Kompressionsverfahrens wurde das Gebiet 20 in eine Vielzahl von untergeordneten Kacheln 17a bis 17e unterteilt, die durch ein- oder mehrfaches Unterteilen der jeweiligen übergeordneten Kacheln erhalten wurden. Beispielhaft sollen nun die komprimierten Daten an einem Punkt in der untergeordneten Kachel 17e ausgewertet werden. Wenn also eine Auswertung an einem gegebenen Punkt x erfolgen soll, wird zunächst jene Kachel 17e bestimmt, in welcher der Punkt x liegt (Schritt 18). Es wird dann die gefundene untergeordnete Kachel 17e separiert 21 und die Auswertung mit der approximierenden Funktion g der untergeordneten Kachel 17e ausgeführt 19. Approximierende Funktionen, Koeffizienten oder Daten anderer Kacheln 17a, 17b, 17c, 17d werden bei der Auswertung der komprimierten Daten in der Kachel 17e nicht berücksichtigt. Entsprechend wird eine Auswertung auf jeder anderen untergeordneten Kachel 17a, 17b, 17c, 17d ohne Berücksichtigung der jeweils anderen untergeordneten Kacheln erfolgen.

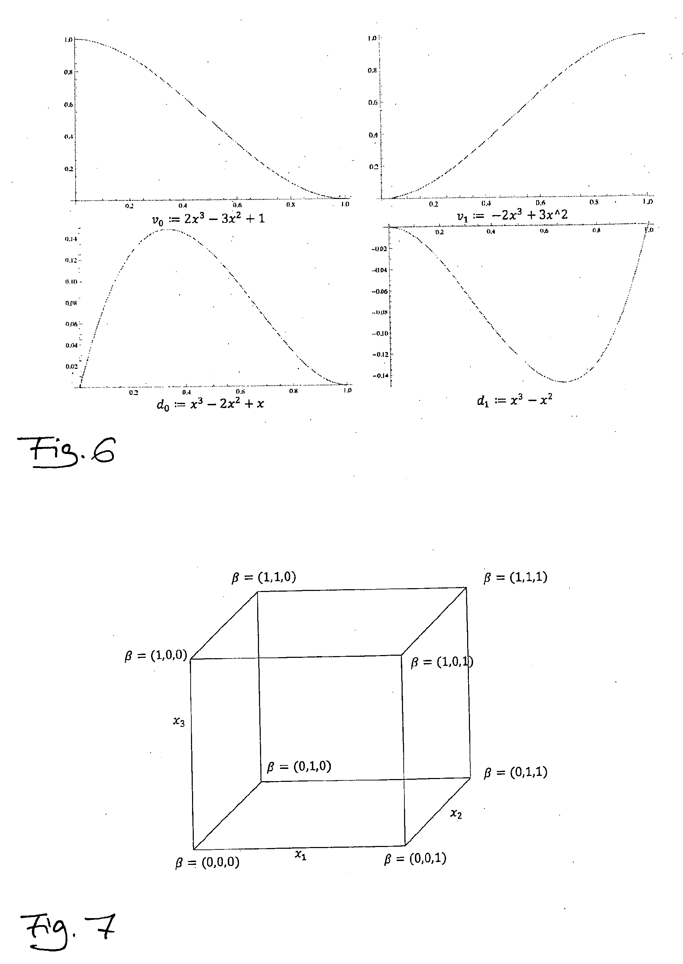

Figur 6 zeigt ein Beispiel, wie aus vier Basisfunktionen, die hier kubische, hermitesche Splines sind, eine approximierende Funktion dritter Ordnung auf einer gegebenen Kachel erzielt werden kann. Bei geeigneter Wahl des Unterteilungsalgorithmus ist die approximierende Funktion global stetig differenzierbar. Im gezeigten Beispiel besteht die Basis auf einer eindimensionalen Kachel K, also einem Intervall, hier [0,1], aus vier Funktionen, die beispielsweise $\{v_0, v_1, d_0, d_1\}$ genannt werden. Diese vier Basisfunktionen sind in Figur 6 in den vier Teilbildern gezeigt. Die Basisfunktionen sind derart gewählt, dass $v_0$ am linken bzw. $v_1$ am rechten Intervallrand den Wert 1 und am jeweils anderen Rand den Wert 0 haben. Die Ableitungen verschwinden an beiden Rändern. Bei $d_0$ und $d_1$ verhält es sich genau umgekehrt: Die Funktionswerte verschwinden auf den Rändern und die Ableitungen sind auf den entsprechenden Rändern 1 und 0 (im Falle von $d_0$) bzw. 0 und 1 (im Falle von $d_1$).

Sei $\mathtt{f}\colon \mathbb{R} \to \mathbb{R}$ eine auf dem Rand der Kachel K= [a,b] differenzierbare Funktion, dann ist $g(x):=f(a)^*v_0(x)$ $+f(b)^*v_1(x)+[f'(a)^*d_0(x)+f'(b)^*d_1(x)](b\text{-}a)$ ein kubisches Polynom, das f auf der Kachel K derart approximiert/interpoliert, dass sowohl ihre Funktionswerte als auch ihre Ableitungen auf dem Rand der Kachel mit f übereinstimmen.

Diese Idee kann für beliebige Dimensionen erweitert werden. Es kann eine allgemeine Basis mit den approximierenden/interpolierenden Eigenschaften der eindimensionalen kubischen, Hermite'schen Basis für d Dimensionen wie folgt konstruiert werden:

Diese Basis B hat $4^d$ Elemente, welche sich mit einer 2d-stelligen Binärzahl wie folgt abzählen lassen: Je zwei aufeinanderfolgende Bits dieser Binärzahl charakterisieren eine der Basen $\{v_0, v_1, d_0, d_1\}$ (was $\{v_{00},v_{01},v_{10},v_{11}\}$ in der allgemeien Beschreibung entspricht). Dabei steht das höherwertige dieser beiden Bits für v oder d und das niederwertige Bit für den Index 0 oder 1.

Zum Beispiel: Basis Nummer 28 hat die Binärdarstellung 01|11|00. Übersetzt man die höherwertigen Bits jedes Zweierpaares als (0→v, 1→d), erhält man v1|d1|v0. Diese Basis berechnet sich nun als Tensor der eindimensionalen Basisfunktionen: $v_1d_1v_0(x_2,x_1,x_0):=v_1(x_2)^*d_1(x_1)^*v_0(x_0)$. Gleichzeitig lässt sich an der Binärdarstellung feststellen, welcher Koeffizient zu dieser Basisfunktion gehört: Die niederwertigen Bits der Paare (untere Indizes) bilden einen Multiindex $\beta=(\beta_1,...,\beta_d)$, $\beta_i\in\{0,1\}$ (im Beispiel $\beta=(1,1,0)$) und adressieren somit direkt eine der $2^d$ Ecken der Kachel. In unserem Beispiel ist es die Ecke 1|1|0, also in Richtung des Parameters $x_0$ die untere und in Richtung $x_1$ und $x_2$ jeweils die obere. Figur 7 zeigt, wie mit dem Multiindex $\beta$ die Ecken einer Kachel beschreibbar sind.

Allgemein lässt sich sagen: Eine Kachel K ist ein d-dimensionaler Hyperquader $K := \times_{i=1}^{d}\left[l_{i_0}, l_{i_1}\right]$. Dabei sind $l_{i0}$ und $l_{i1}$ die untere und obere Intervallgrenze der i-ten Dimension. Ein Eckpunkt P einer Kachel kann nun über den Multiindex $\beta = (\beta_1,...,\beta_d)$ eindeutig bestimmt werden: $P(\beta) := \left(l_{1_{\beta_1}}, ..., l_{d_{\beta_d}}\right)$. In diesem Beispiel mit $\beta=(\beta_1,...,\beta_d)=(1,1,0)$ ergibt das $P(\beta) := \left(l_{1_1}, l_{2_1}, l_{3_0}\right)$. Die höherwertigen Bits der Paare geben einen Multiindex $\alpha=(\alpha_1,...,\alpha_2)$, $\alpha_i\in\{0,1\}$ der gemischten Ableitung (im Beispiel $vdv \cong \alpha = (0,1,0)$) der zu approximierenden/interpolierenden Funktion an. In unserem Beispiel ist $\alpha = (0,1,0)$, was bedeutet, dass der zu $v_1d_1v_0(x_2,x_1,x_0)$ gehörige Koeffizient ermittelt werden kann, indem

die gemischte Ableitung $\dfrac{\partial^{|\alpha|}}{(\partial x)^{\alpha}}$ der zu approximierenden/interpolierenden Funktion an der Ecke

$P(\beta) := \left(l_{1_{\beta_1}}, ..., l_{d_{\beta_d}}\right)$ ausgewertet wird. Also $\dfrac{\partial^{|\alpha|}}{(\partial x)^{\alpha}} f(P(\beta))$.

Allgemein lässt sich das vorstehend beschriebene Beispiel wie folgt in geschlossener Form beschreiben. Es werden für eine gegebene Kachel $K := \times_{i=1}^{d}\left[l_{i_o}, l_{i1}\right]$ Basisfunktionen $\gamma$ definiert als

$$\text{je} \quad \gamma_{\vec{\alpha}_k}(x_{d-1}, ..., x_0) = \prod_{i=0}^{d-1} \nu_{\alpha_i}(x_{d-1-i})s_i \quad \text{mit} \quad s_i := \begin{cases} 1, falls \, \alpha_{i_1} = 0 \\ l_{i_1} - l_{i_0}, falls \, \alpha_{i_1} = 1 \end{cases}$$

mit

$$\vec{\alpha}_k = (\alpha_0, ..., \alpha_{d-1}), \quad k = 0, ...., 4^d - 1, \quad \alpha_i := (\alpha_{i_1}, \alpha_{i_1}) \in \{(0,0),(0,1),(1,0),(1,1)\}$$

$i=0,......,d$-1 und $\overleftarrow{\alpha}_k \neq \overleftarrow{\alpha}_l$ für $k \neq l$
wobei

$$\nu_{00} \quad := \quad 2x^3 - 3x^2 + 1$$

$$\nu_{01} \quad := \quad -2x^3 + 3x^2$$

$$\nu_{10} \quad := \quad x^3 - 2x^2 + x$$

$$\nu_{11} \quad := \quad x^3 - x^2$$

und wobei die approximierende Funktion g der Daten $f(x_0,..., x_{d-1})$ definiert wird als

$$g(x_{d-1}, ....., x_0) = \sum_{\substack{\vec{\alpha}_k \\ k=0...4^d-1}} \gamma_{\vec{\alpha}_k}(x_{d-1}, ......, x_0)\lambda(L_0,..., L_i,..., L_{d-1})$$

wobei

$$\lambda(L_0,..., L_i,..., L_{d-1}) = \frac{\partial^{\left(\sum_{i=0}^{d-1}\alpha_{i_1}\right)}}{(\partial x_0)^{\alpha_{0_1}}.....(\partial x_{d-1})^{\alpha_{d-1_1}}} f(x_0,..., x_{d-1})\bigg|_{L_0,..., L_{d-1}}$$

mit $L_i = l_{i_{\alpha_{i_2}}}$ .

**Patentansprüche**

1.  Verfahren zur Kompression von Daten, wobei die Daten in einem d-dimensionalen Gebiet vorliegen, wobei das Gebiet als eine übergeordnete Kachel gesetzt wird, und danach
    in einem Teilungsschritt die übergeordnete Kachel in eine Mehrzahl von d-dimensionalen untergeordneten Kacheln unterteilt wird, so dass eine Vereinigung aller der in diesem Teilungsschritt erzeugten untergeordneten Kacheln kongruent zur Vereinigung aller in diesem Teilungsschritt unterteilten übergeordneten Kacheln ist und eine Schnittmenge zweier unterschiedlicher untergeordneter Kacheln leer ist oder ein maximal (d-1)-dimensionaler Rand beider untergeordneter Kacheln ist, dann

in einem Approximationsschritt für jede der untergeordneten Kacheln zumindest eine approximierende Funktion zur Approximation der Daten in der entsprechenden untergeordneten Kachel ermittelt wird, dann

in einem Fehlerbestimmungsschritt ein Fehler der approximierenden Funktionen im Vergleich zu den Daten ermittelt wird, und dann

in einem Entscheidungsschritt

wenn der Fehler einen Schwellenwert unterschreitet, Daten, welche die untergeordneten Kacheln und die auf ihnen ermittelten approximierenden Funktionen beschreiben, als komprimierte Daten gesetzt werden, und

wenn der Fehler größer ist als der Schwellenwert zumindest ein Teil der untergeordneten Kacheln als übergeordnete Kacheln gesetzt werden, für diese jeweils der Teilungsschritt und der Approximationsschritt durchgeführt wird und für alle untergeordneten Kacheln der Fehlerbestimmungsschritt und der Entscheidungsschritt durchgeführt wird.

2. Verfahren nach dem vorhergehenden Anspruch, **dadurch gekennzeichnet, dass** in den Fehlerbestimmungsschritten jeweils eine Fehlerfunktion ermittelt wird, die den Fehler ortsabhängig in einem Teil des Gebietes oder dem gesamten Gebiet beschreibt, und dass in den Teilungsschritten die Unterteilung der übergeordneten Kacheln anhand der Fehlerfunktion erfolgt und/oder dass in Bereichen, in denen die Daten eine größere Volatilität, vorzugsweise einen größeren Gradienten aufweisen, in mehr untergeordnete Kacheln unterteilt wird als in Bereichen, in denen die Daten einen kleineren Gradienten aufweisen.

3. Verfahren nach dem vorhergehenden Anspruch, **dadurch gekennzeichnet, dass** die Fehlerfunktion e den ortsabhängigen Fehler in einer Umgebung D(x) um einen Ort x im Gebiet angibt als

$$e(x) := \left| f(x) - g(x) \right| / (M(x) - m(x))$$

mit $M(x) := max_{p \in D(x)}(f(p))$ und $m(x) := min_{p \in D(x)}(f(p))$ und/oder den Fehler angibt als $e := \|f-g\|$, unter Verwendung einer globalen Norm und/oder Metrik, vorzugsweise einer Lebesgue-Norm Lp, Sobolev-Norm $W^q_p$, Wasserstein-

Metrik und/oder einer Vektornorm $\left\| f - g \right\|_{l_p} := \left\{ \left( \sum_{i=0}^{n} |f_i - g_i|^p \right)^{\frac{1}{p}} \right\}$, mit n als Anzahl aller Werte der

Ursprungsdaten und $g_i$ als approximierende Funktion am i-ten Punkt auf den Daten, und wobei vorzugsweise ein globaler Fehler und/oder ein lokaler Fehler angegeben wird, und/oder wobei weiter bevorzugt die Normen die Approximationsgüte und/oder den lokalen Fehler messen können, insbesondere, wenn sie lokal eingeschränkt werden, vorzugsweise durch Multiplikation mit Kernen und/oder anderen Funktionen mit kompaktem Träger gemäß

$$e(x) := \left\| (f(\cdot) - g(\cdot)) * k(x - \cdot) \right\|_{L_p} := \sqrt[p]{\int ((f(z) - g(z)) * k(x - z))^p \, dz}.$$

4. Verfahren nach einem der vorhergehenden Ansprüche,
**dadurch gekennzeichnet, dass** eine, mehrere oder alle der approximierenden Funktionen durch eine Linearkombination von zumindest zwei jeweils mit einem Koeffizienten multiplizierten und vorzugsweise orthogonalen Basisfunktionen gebildet werden, wobei vorzugsweise die Koeffizienten aus den Daten ermittelt werden, und/oder wobei vorzugsweise die approximierende Funktion g(x) berechnet wird als

$$g(x) := \sum_{i=0}^{N} \lambda_{K_i} \bullet b_i(x_K) \, ,$$

wobei $x_K \in K$ ein Ort in der Kachel K ist, $b_i$ die Basisfunktionen der Kachel, $\lambda_K$ die Koeffizienten der Kachel und N ist eine natürliche Zahl, wobei N ≥ 1.

**5.** Verfahren nach einem der Ansprüche 2 bis 4, **dadurch gekennzeichnet, dass** im Teilungsschritt die übergeordnete Kachel so unterteilt wird, dass die Zahl der untergeordneten Kacheln möglichst klein ist und der gemäß der im vorausgegangenen Fehlerbestimmungsschritt bestimmten Fehlerfunktion bestimmte Fehler möglichst klein ist, wobei vorzugsweise im Teilungsschritt so unterteilt wird, dass ein Punkt, in welchem die Fehlerfunktion ein Maximum annimmt, auf einer Teilungsebene liegt, entlang der die entsprechende übergeordnete Kachel unterteilt wird.

**6.** Verfahren nach einem der vorhergehenden Ansprüche,
**dadurch gekennzeichnet, dass** vor dem ersten Teilungsschritt eine Fehlerfunktion für das Gebiet ermittelt wird und dass im ersten Teilungsschritt die Unterteilung der übergeordneten Kachel, die das Gebiet ist, anhand dieser Fehlerfunktion erfolgt.

**7.** Verfahren nach einem der vorhergehenden Ansprüche,
**dadurch gekennzeichnet, dass** im Teilungsschritt die übergeordneten Kacheln in untergeordnete Kacheln geteilt werden, indem die übergeordnete Kachel in zumindest einer Richtung entlang einer (d-1)-dimensionalen Ebene durchtrennt wird.

**8.** Verfahren nach einem der vorhergehenden Ansprüche,
**dadurch gekennzeichnet, dass** approximierende Funktionen zweier Kacheln, die über einen Rand aneinander grenzen, auf dem Rand stetig, vorzugsweise stetig differenzierbar, ineinander übergehen.

**9.** Verfahren nach einem der vorhergehenden Ansprüche,
**dadurch gekennzeichnet, dass** die approximierenden Funktionen einer Kachel ohne Einfluss von Daten anderer Kacheln ermittelt wird.

**10.** Verfahren nach einem der vorhergehenden Ansprüche,
**dadurch gekennzeichnet, dass** die approximierende Funktion aus Basisfunktionen konstruiert wird, welche kubische, hermitesche Splines sind, wobei für eine gegebene Kachel $k := \times_{i=1}^{d} \left[ l_{i_0}, l_{i_1} \right]$ $4^d$ Basisfunktionen $\gamma$ definiert werden als

$$\text{je} \quad \gamma_{\vec{\alpha}_k}(x_{d-1}, \dots, x_0) = \prod_{i=0}^{d-1} v_{\alpha_i}(x_{d-1-i}) s_i$$

mit

$$s_i := \left\{ \begin{array}{l} 1, falls\, \alpha_{i_1} = 0 \\ l_{i_1} - l_{i_0}, falls\, \alpha_{i_1} = 1 \end{array} \right\}$$

und mit

$$\vec{\alpha}_k = (\alpha_0, \dots, \alpha_{d-1}), \quad k = 0, \dots, 4^d - 1,$$

$$\alpha_i := (\alpha_{i_1}, \alpha_{i_2}) \in \left\{ (0,0), (0,1), (1,0), (1,1) \right\}$$

$i=0,\dots,d$-1 und $\overline{\alpha}_k \neq \overline{\alpha}_l$ für $k \neq l$ wobei

$$v_{00} := 2x^3 - 3x^2 + 1$$

$$v_{01} \quad := \quad -2x^3 + 3x^2$$

$$v_{10} \quad := \quad x^3 - 2x^2 + x$$

$$v_{11} \quad := \quad x^3 - x^2$$

und wobei die approximierende Funktion g der Daten $f(x_0,..., x_{d-1})$ definiert wird als

$$g(x_{d-1}, ....., x_0) = \sum_{\substack{\vec{a}_k \\ k=0...4^d-1}} \gamma_{\tilde{a}_k}(x_{d-1}, ......, x_0)\lambda\left(L_0,..., L_i,..., L_{d-1}\right)$$

wobei

$$\lambda\left(L_0,..., L_i,..., L_{d-1}\right) = \frac{\partial^{\left(\sum_{i=0}^{d-1}\alpha_{l_i}\right)}}{(\partial x_0)^{\alpha_{0_1}}.....(\partial x_{d-1})^{\alpha_{d-l_1}}} f(x_0,..., x_{d-1})\Bigg|_{L_0,..., L_{d-1}}$$

mit $L_i = l_{i_{\alpha_{i_2}}}$ und/oder dass die Basisfunktionen auf jeder Kachel eigenständig definierte konstante, lineare, quadratische, kubische Polynome oder Polynome höheren Grades sind, und/oder dass die Basisfunktionen auf jeder Kachel eigenständig definierte Non-uniform rational B-Splines NURBS, Parametrisierte Untermannigfaligkeiten, sind und/oder dass die Basisfunktionen auf jeder Kachel eigenständig definierte Trigonomterische Funktionen sind und/oder dass die Basisfunktionen auf jeder Kachel eigenständig definierte Wavelets sind.

11. Verfahren zum Speichern und/oder Senden von Daten mit geringem Speicherbedarf und/oder Übertragungskapazitätsbedarf, wobei vor und/oder während dem Speichern und/oder Senden die zu speichernden und/oder zu sendenden Daten mittels eines Verfahrens nach einem der vorhergehenden Ansprüche komprimiert werden.

12. Verfahren zum Auslesen von Daten aus einem Speicher und/oder zum Empfangen von Daten, wobei die Daten in einem Verfahren nach einem der vorhergehenden Ansprüche komprimiert sind, und wobei eine Auswerteeinheit, die auf unkomprimierte Daten anwendbar ist, auf die approximierenden Funktionen jener Kachel, in welcher x liegt, am Ort x angewendet wird, ohne dass Approximationen von Daten anderer Kacheln eingehen, und wobei vorzugsweise die Daten vor der Auswertung nicht dekomprimiert werden.

13. Komprimierungsvorrichtung zur Kompression von Daten, die in einem d-dimensionalen Gebiet vorliegen, mit einer Setzungsvorrichtung, mit welcher das Gebiet als eine übergeordnete Kachel setzbar ist, einer Teilungsvorrichtung, mit welcher die übergeordnete Kachel in eine Mehrzahl von d-dimensionalen untergeordneten Kacheln unterteilbar ist, so dass eine Vereinigung aller der untergeordneten Kacheln kongruent zur Vereinigung aller in einem vorangegangenen Teilungsschritt unterteilten übergeordneten Kacheln ist, und eine Schnittmenge zweier unterschiedlicher untergeordneter Kacheln leer ist oder ein maximal (d-1)-dimensionaler Rand beider untergeordneter Kacheln ist,
einer Approximationseinheit zur Ermittlung zumindest einer approximierenden Funktion für jede der untergeordneten Kacheln zur Approximation der Daten in der entsprechenden untergeordneten Kachel,
einer Fehlerbestimmungseinheit, mit welcher ein Fehler der approximierenden Funktionen im Vergleich zu den Daten ermittelbar ist,
einer Entscheidungseinheit, mit welcher entscheidbar ist, ob der Fehler einen Schwellenwert unterschreitet,
einer Speichereinheit, zum Speichern von Daten, welche die untergeordneten Kacheln und die auf ihnen ermittelten approximierenden Funktionen beschreiben als komprimierte Daten, wenn durch die Entscheidungseinheit festgestellt wird, dass der Schwellenwert unterschritten ist,
sowie einer Setzungseinheit, mit welcher, wenn die Entscheidungseinheit entscheidet, dass der Fehler größer ist als der Schwellenwert, zumindest ein Teil der untergeordneten Kacheln als übergeordnete Kacheln setzbar ist und diese der Teilungseinheit und der Approximationseinheit zuführbar sind, wobei, wenn die Entscheidungseinheit feststellt, dass der Fehler größer ist als der Schwellenwert, alle untergeordneten Kacheln der Fehlerbestimmungseinheit und der Entscheidungseinheit zuführbar sind.

14. Vorrichtung nach dem vorhergehenden Anspruch, **dadurch gekennzeichnet, dass** mit dieser Vorrichtung ein Verfahren nach einem der Ansprüche 1 bis 11 durchführbar ist.

15. Auswertungsvorrichtung zum Auswerten von komprimierten Daten, mit welcher ein Verfahren nach Anspruch 12 durchführbar ist.

Erzeuge triviale, approximierende Funktion (Master-Kachel) — 1

Fehlerberechnung 2

Adaptives splitting 3

Fig. 1

4

5

Komprimierte Daten / Approximierende

Originaldaten

6 — Auswerteeinheit

Auswerteeinheit — 7

Vergleich — 8

Fehlerfunktion — 9

Fig. 2

Fehlerfunktion

Ermittlung des optimalen Splitpunktes und der optimalen Splitrichtung. — 11

Betroffene Kacheln durch neue Subkacheln ersetzen. — 12

10

**Fig. 3**

14

Splitpunkt

+

Splitrichtung: x

16

13

15

z

x

y

15

**Fig. 4**

17d

17c

17b

17e

Suche eindeutige Kachel, die
d-dimensionalen Parameter
$(x_0, x_1, x_2, \dots, x_{d-1})$ enthält.

18

20

17a

21

Werte die approximierende Funktion
$g(x_0, x_1, x_2, \dots, x_{d-1})$ der Kachel aus.

17e

Fig. 5

19

EP 2 391 015 A1

$$v_0 := 2x^3 - 3x^2 + 1$$

$$v_1 := -2x^3 + 3x^2$$

$$d_0 := x^3 - 2x^2 + x$$

$$d_1 := x^3 - x^2$$

Fig. 6

$\beta = (1,1,0)$  $\beta = (1,1,1)$
$\beta = (1,0,0)$  $\beta = (1,0,1)$
$x_3$
$\beta = (0,1,0)$  $\beta = (0,1,1)$
$x_2$
$\beta = (0,0,0)$  $x_1$  $\beta = (0,0,1)$

Fig. 7

19

Europäisches
Patentamt

European
Patent Office

Office européen
des brevets

## EUROPÄISCHER RECHERCHENBERICHT

Nummer der Anmeldung

EP 10 00 5653

### EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (IPC) |
|---|---|---|---|
| X | LI CHUANG; PLASSMANN PAUL E.: "An Efficient Algorithm for the Compression of Time-Dependent Data from Scientific Simulations", PROCEEDINGS OF THE 2003 INTERNATIONAL CONFERENCE ON COMPUTATIONAL SCIENCE AND ITS APPLICATIONS, 2003, Seiten 291-301, XP002607455, | 1,2,6,7, 9,13,14 | INV. H03M7/30 |
| Y | * das ganze Dokument * | 4,10,12, 14,15 | |
| | ----- | | |
| Y | SHATKAY H ET AL: "Approximate queries and representations for large data sequences", DATA ENGINEERING, 1996. PROCEEDINGS OF THE TWELFTH INTERNATIONAL CONFE RENCE ON NEW ORLEANS, LA, USA 26 FEB.-1 MARCH 1996, LOS ALAMITOS, CA, USA,IEEE COMPUT. SOC, US, 26. Februar 1996 (1996-02-26), Seiten 536-545, XP010158955, DOI: DOI:10.1109/ICDE.1996.492204 ISBN: 978-0-8186-7240-8 * Seite 540, linke Spalte, Zeile 12 - Zeile 14 * * Seite 542, linke Spalte, Zeile 14 - rechte Spalte, Zeile 23 * | 4,10,14 | RECHERCHIERTE SACHGEBIETE (IPC) H03M |
| | ----- | | |
| Y | Lang Marco: "High-quality objects in games through high-definition silhouettes", , Dezember 2004 (2004-12), Seiten 1-81, XP002634822, Gefunden im Internet: URL:http://www.uni-koblenz.de/~cg/Diplomar beiten/langmarco.pdf [gefunden am 2011-04-28] * Seite 14, letzten 6 Zeilen * * Seite 20, Zeile 1 - Seite 23, Zeile 7 * | 4,10,14 | |
| | ----- | | |
| | -/-- | | |

~~Der vorliegende Recherchenbericht wurde für alle Patentans~~prüche erstellt

| Recherchenort | Abschlußdatum der Recherche | Prüfer |
|---|---|---|
| München | 2. Mai 2011 | Winkler, Gregor |

KATEGORIE DER GENANNTEN DOKUMENTE

X : von besonderer Bedeutung allein betrachtet
Y : von besonderer Bedeutung in Verbindung mit einer anderen Veröffentlichung derselben Kategorie
A : technologischer Hintergrund
O : nichtschriftliche Offenbarung
P : Zwischenliteratur

T : der Erfindung zugrunde liegende Theorien oder Grundsätze
E : älteres Patentdokument, das jedoch erst am oder nach dem Anmeldedatum veröffentlicht worden ist
D : in der Anmeldung angeführtes Dokument
L : aus anderen Gründen angeführtes Dokument
.................................................................
& : Mitglied der gleichen Patentfamilie, übereinstimmendes Dokument

EPO FORM 1503 03.82 (P04C03)

Europäisches
Patentamt

European
Patent Office

Office européen
des brevets

**EUROPÄISCHER RECHERCHENBERICHT**

Nummer der Anmeldung

EP 10 00 5653

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (IPC) |
|---|---|---|---|
| Y | DROR ALANI ET AL: "Image Coding With Geometric Wavelets", IEEE TRANSACTIONS ON IMAGE PROCESSING, IEEE SERVICE CENTER, PISCATAWAY, NJ, US, Bd. 16, Nr. 1, 1. Januar 2007 (2007-01-01), Seiten 69-77, XP011151941, ISSN: 1057-7149, DOI: DOI:10.1109/TIP.2006.887727 * Seite 69, Gleichung 2 und die folgende Zeile * * Abbildung 1 * ----- | 10,14 | |
| Y | KOUTSOUDIS A ET AL: "Qp: A tool for generating 3D models of ancient Greek pottery", JOURNAL OF CULTURAL HERITAGE, EDITIONS SCIENTIFIQUES ET MEDICALES ELSEVIER, Bd. 10, Nr. 2, 1. April 2009 (2009-04-01), Seiten 281-295, XP026132742, ISSN: 1296-2074, DOI: DOI:10.1016/J.CULHER.2008.07.012 [gefunden am 2009-05-22] * Seite 286, rechte Spalte, letzte Zeile - Seite 287, linke Spalte, Zeile 5 * ----- | 4,10,14 | |
| Y | GOBBETTI E ET AL: "Technical strategies for massive model visualization", ACM SIGGRAPH ASIA 2008 COURSES, SIGGRAPH ASIA'08 - ACM SIGGRAPH ASIA 2008 COURSES, SIGGRAPH ASIA'08 2008 ASSOCIATION FOR COMPUTING MACHINERY USA, 2. Juni 2008 (2008-06-02), Seiten 405-415, XP002634823, DOI: DOI:10.1145/1508044.1508073 * Seite 406, linke Spalte, Absatz 5 * * Seite 411, rechte Spalte, letzter Absatz - Seite 412, linke Spalte, Absatz 1 * ----- -/-- | 12,15 | RECHERCHIERTE SACHGEBIETE (IPC) |

~~Der vorliegende Recherchenbericht wurde für alle Patentans~~prüche erstellt

| Recherchenort | Abschlußdatum der Recherche | Prüfer |
|---|---|---|
| München | 2. Mai 2011 | Winkler, Gregor |

KATEGORIE DER GENANNTEN DOKUMENTE

X : von besonderer Bedeutung allein betrachtet
Y : von besonderer Bedeutung in Verbindung mit einer
   anderen Veröffentlichung derselben Kategorie
A : technologischer Hintergrund
O : nichtschriftliche Offenbarung
P : Zwischenliteratur

T : der Erfindung zugrunde liegende Theorien oder Grundsätze
E : älteres Patentdokument, das jedoch erst am oder
   nach dem Anmeldedatum veröffentlicht worden ist
D : in der Anmeldung angeführtes Dokument
L : aus anderen Gründen angeführtes Dokument

&: Mitglied der gleichen Patentfamilie, übereinstimmendes
   Dokument

EPO FORM 1503 03.82 (P04C03)

Europäisches
Patentamt

European
Patent Office

Office européen
des brevets

## EUROPÄISCHER RECHERCHENBERICHT

Nummer der Anmeldung

EP 10 00 5653

### EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (IPC) |
|---|---|---|---|
| Y | SUNGYUL CHOE ET AL: "Random Accessible Mesh Compression Using Mesh Chartification", IEEE TRANSACTIONS ON VISUALIZATION AND COMPUTER GRAPHICS, IEEE SERVICE CENTER, LOS ALAMITOS, CA, US, Bd. 15, Nr. 1, 1. Januar 2009 (2009-01-01), Seiten 160-173, XP011266517, ISSN: 1077-2626, DOI: DOI:10.1109/TVCG.2008.64 * Seite 160, rechte Spalte, Zeile 1 - Zeile 13 * * Seite 161, linke Spalte, letzter Absatz - rechte Spalte, Zeile 25 * ----- | 12,15 | |
| A | KEOGH E ET AL: "An online algorithm for segmenting time series", DATA MINING, 2001. ICDM 2001, PROCEEDINGS IEEE INTERNATIONAL CONFERENC E ON SAN JOSE, CA, USA 29 NOV.-2 DEC. 2001, LOS ALAMITOS, CA, USA,IEEE COMPUT. SOC, US LNKD- DOI:10.1109/ICDM.2001.989531, 29. November 2001 (2001-11-29), Seiten 289-296, XP010583289, ISBN: 978-0-7695-1119-1 * Seite 290, linke Spalte, Zeile 21 - Seite 292, linke Spalte, Zeile 12 * ----- | 1,13 | |
| A | KUNT M ET AL: "RECENT RESULTS IN HIGH-COMPRESSION IMAGE CODING", IEEE TRANSACTIONS ON CIRCUITS AND SYSTEMS, IEEE INC. NEW YORK, US, Bd. CAS-34, Nr. 11, 1. November 1987 (1987-11-01), Seiten 1306-1336, XP000037993, DOI: DOI:10.1109/TCS.1987.1086071 * Seite 1325, rechte Spalte, Zeile 6 - Zeile 15 * ----- | 1,4,10, 13,14 | RECHERCHIERTE SACHGEBIETE (IPC) |

~~Der vorliegende Recherchenbericht wurde für alle Patentansprüche erstellt~~

| Recherchenort | Abschlußdatum der Recherche | Prüfer |
|---|---|---|
| München | 2. Mai 2011 | Winkler, Gregor |

KATEGORIE DER GENANNTEN DOKUMENTE

X : von besonderer Bedeutung allein betrachtet
Y : von besonderer Bedeutung in Verbindung mit einer
    anderen Veröffentlichung derselben Kategorie
A : technologischer Hintergrund
O : nichtschriftliche Offenbarung
P : Zwischenliteratur

T : der Erfindung zugrunde liegende Theorien oder Grundsätze
E : älteres Patentdokument, das jedoch erst am oder
    nach dem Anmeldedatum veröffentlicht worden ist
D : in der Anmeldung angeführtes Dokument
L : aus anderen Gründen angeführtes Dokument
........................................................................................................
& : Mitglied der gleichen Patentfamilie, übereinstimmendes
    Dokument

EPO FORM 1503 03.82 (P04C03)

Europäisches
Patentamt

European
Patent Office

Office européen
des brevets

## GEBÜHRENPFLICHTIGE PATENTANSPRÜCHE

Die vorliegende europäische Patentanmeldung enthielt bei ihrer Einreichung Patentansprüche, für die eine Zahlung fällig war.

☐ Nur ein Teil der Anspruchsgebühren wurde innerhalb der vorgeschriebenen Frist entrichtet. Der vorliegende europäische Recherchenbericht wurde für jene Patentansprüche erstellt, für die keine Zahlung fällig war, sowie für die Patentansprüche, für die Anspruchsgebühren entrichtet wurden, nämlich Patentansprüche:

☐ Keine der Anspruchsgebühren wurde innerhalb der vorgeschriebenen Frist entrichtet. Der vorliegende europäische Recherchenbericht wurde für die Patentansprüche erstellt, für die keine Zahlung fällig war.

## MANGELNDE EINHEITLICHKEIT DER ERFINDUNG

Nach Auffassung der Recherchenabteilung entspricht die vorliegende europäische Patentanmeldung nicht den Anforderungen an die Einheitlichkeit der Erfindung und enthält mehrere Erfindungen oder Gruppen von Erfindungen, nämlich:

Siehe Ergänzungsblatt B

☐ Alle weiteren Recherchengebühren wurden innerhalb der gesetzten Frist entrichtet. Der vorliegende europäische Recherchenbericht wurde für alle Patentansprüche erstellt.

☐ Da für alle recherchierbaren Ansprüche die Recherche ohne einen Arbeitsaufwand durchgeführt werden konnte, der eine zusätzliche Recherchengebühr gerechtfertigt hätte, hat die Recherchenabteilung nicht zur Zahlung einer solchen Gebühr aufgefordert.

☒ Nur ein Teil der weiteren Recherchengebühren wurde innerhalb der gesetzten Frist entrichtet. Der vorliegende europäische Recherchenbericht wurde für die Teile der Anmeldung erstellt, die sich auf Erfindungen beziehen, für die Recherchengebühren entrichtet worden sind, nämlich Patentansprüche:

4, 10, 12, 15(vollständig); 14(teilweise)

☐ Keine der weiteren Recherchengebühren wurde innerhalb der gesetzten Frist entrichtet. Der vorliegende europäische Recherchenbericht wurde für die Teile der Anmeldung erstellt, die sich auf die zuerst in den Patentansprüchen erwähnte Erfindung beziehen, nämlich Patentansprüche:

☐ Der vorliegende ergänzende europäische Recherchenbericht wurde für die Teile der Anmeldung erstellt, die sich auf die zuerst in den Patentansprüchen erwähnte Erfindung beziehen (Regel 164 (1) EPÜ).

Europäisches
Patentamt

European
Patent Office

Office européen
des brevets

**MANGELNDE EINHEITLICHKEIT
DER ERFINDUNG
ERGÄNZUNGSBLATT B**

Nummer der Anmeldung

EP 10 00 5653

Nach Auffassung der Recherchenabteilung entspricht die vorliegende europäische Patentanmeldung nicht den Anforderungen an die Einheitlichkeit der Erfindung und enthält mehrere Erfindungen oder Gruppen von Erfindungen, nämlich:

1. Ansprüche: 1, 6, 7, 9, 11, 13(vollständig); 2, 14(teilweise)

   Erfindung 1 wird durch den Anspruche 1 in Verbindung mit der zweiten Alternative aus Anspruch 2 ("dass in Bereichen, in denen die Daten eine größeren Volatilität," ..."in mehr untergeordnete Kachel unterteilt wird als in Bereichen, in denen die Daten einen kleineren Gradienten aufweisen") definiert sowie durch Anspruch 13 in Verbindung mit Anspruch 14, wenn dieser auf die zweite Alternative aus Anspruch 2 verweist.
   Die zweite Alternative in Anspruch 2 stellt die besonderen technischen Merkmale dar, die die erste Erfindung definieren.
   Diese besonderen technischen Merkmale lösen das Problem, dass die Anzahl der Iterationen der Unterteilung reduziert werde, da in einem Schritt eine variable Mehrfachunterteilung erfolgt.
   ---

2. Ansprüche: 3(vollständig); 2, 14(teilweise)

   Erfindung 2 wird durch den Anspruch 1 in Verbindung mit der ersten Alternative aus Anspruch 2 ("dass in den Fehlerbestimmungsschritten ... die Unterteilung der übergeordneten Kachel anhand der Fehlerfunktion erfolgt") und dem Anspruch 3 definiert sowie durch Anspruch 13 in Verbindung mit Anspruch 14, wenn dieser auf die erste Alternative aus Anspruch 2 und den Anspruch 3 verweist.
   Die Merkmale des Anspruchs 3, welche unterschiedliche Fehlerfunktionen definieren, sind die besonderen technischen Merkmale die die zweite Erfindung definieren.
   Diese besonderen technischen Merkmale lösen das Problem, dass alternative Fehlerfunktionen gefunden werden.
   ---

3. Ansprüche: 4, 10(vollständig); 14(teilweise)

   Erfindung 3 wird durch Anspruch 1 in Verbindung mit Anspruch 4, bzw. Anspruch 1 in Verbindung mit Anspruch 10 definiert sowie durch Anspruch 13 in Verbindung mit Anspruch 14, wenn dieser auf Anspruch 4 oder auf Anspruch 10 verweist.
   Die Merkmale des abhängigen Anspruchs 4, welche die approximierende Funktion definieren, sind die besonderen technischen Merkmale die die dritte Erfindung definieren.
   Diese besonderen technischen Merkmale lösen das Problem alternative Approximierungsfunktion zu finden.
   ---

4. Ansprüche: 5(vollständig); 2, 14(teilweise)

   Erfindung 4 wird durch Anspruch 1 in Verbindung mit der

Europäisches
Patentamt

European
Patent Office

Office européen
des brevets

**MANGELNDE EINHEITLICHKEIT
DER ERFINDUNG
ERGÄNZUNGSBLATT B**

**Nummer der Anmeldung**

EP 10 00 5653

Nach Auffassung der Recherchenabteilung entspricht die vorliegende europäische Patentanmeldung nicht den Anforderungen an die Einheitlichkeit der Erfindung und enthält mehrere Erfindungen oder Gruppen von Erfindungen, nämlich:

ersten Alternative aus Anspruch 2 ("dass in den Fehlerbestimmungsschritten ... die Unterteilung der übergeordneten Kachel anhand der Fehlerfunktion erfolgt") und dem Anspruch 5 definiert sowie durch Anspruch 13 in Verbindung mit Anspruch 14, wenn dieser auf die erste Alternative aus Anspruch 2 und den Anspruch 4 verweist.
Die Merkmale des abhängigen Anspruchs 5, welche die Minimierung der Anzahl der Unterteilung und die Minimierung des Fehler, definieren, sind die besonderen technischen Merkmale die die vierte Erfindung definieren.
Diese besonderen technischen Merkmale lösen das Problem gute Teilungspunkte zu finden.
---

5. Ansprüche: 8(vollständig); 14(teilweise)

Erfindung 5 wird durch Anspruch 1 in Verbindung mit Anspruch 8 definiert sowie durch Anspruch 13 in Verbindung mit Anspruch 14, wenn dieser auf Anspruch 8 verweist.
Die Merkmale des abhängigen Anspruchs 8, welche eine Stetigkeit, vorzugsweise eine stetig differenzierbar, approximierenden Funktion am Rand einer Kachel definieren, sind die besonderen technischen Merkmale die die fünfte Erfindung definieren.
Diese besonderen technischen Merkmale lösen das Problem, dass ein kontinuierlicher Eindruck der Approximation erzeugt wird.
---

6. Ansprüche: 12, 15

Erfindung 6 wird durch die Ansprüche 12 und 15 definiert.
Die Merkmale des Anspruchs 12 definieren das Auslesen der komprimierten Daten, wobei eine Auswerteeinheit, die auf unkomprimierte Daten anwendbar ist auf die approximierenden Funktionen jener Kachel, in welcher x liegt, am Ort x angewendet wird, ohne dass approximation von Daten andere Kacheln eingehen und sind die besonderen technischen Merkmale die die sechste Erfindung definieren.
Diese besonderen technischen Merkmale lösen das Problem, dass nicht alle Daten benötigt werde.
---